# EUROPEAN PATENT SPECIFICATION

(11) **EP 3 846 340 B1**
(45) Date of publication and mention of the grant of the patent: **01.11.2023**
(21) Application number: 20212674.4
(22) Date of filing: 09.12.2020
(51) Int. Cl.: H03D 9/02, H03D 9/06

(54) **DEVICE FOR MIXING OR MULTIPLYING FREQUENCY**
VORRICHTUNG ZUM MISCHEN ODER MULTIPLIZIEREN VON FREQUENZEN
DISPOSITIF DE MÉLANGE OU DE MULTIPLICATION DE FRÉQUENCE

(30) Priority: 31.12.2019 CN 201911425658
(43) Date of publication of application: 07.07.2021
(73) Proprietor: Tsinghua University, Beijing 100084 (CN); Nuctech Company Limited, TongFang Building Shuangqinglu Haidian District Beijing 100084 (CN)
(72) Inventor: CHEN, Zhiqiang, Beijing 100084 (CN); LI, Yuanjing, Beijing 100084 (CN); ZHAO, Ziran, Beijing 100084 (CN); HU, Haifan, Beijing 100084 (CN); MA, Xuming, Beijing 100084 (CN); HUANG, Shiwei, Beijing 100084 (CN)
(74) Representative: Gunzelmann, Rainer

(56) References cited:
- CN-A- 109 509 952
- CN-U- 202 888 829
- CN-U- 209 133 660

## Description

### TECHNICAL FIELD

The present disclosure relates to a field of communication technology, and in particular to a device for mixing or multiplying frequency.

### BACKGROUND

In recent years, terahertz wave technology, as an important research field, has attracted more and more attention at home and abroad. However, no matter which aspect and frequency band the terahertz wave is applied to, the reception of the terahertz wave is necessary. For the most commonly used receiver based on superheterodyne system, a mixer for frequency down conversion is a key component. In a solid-state terahertz radar and communications system, because a low-noise amplifier is difficult to implement, the mixer becomes the first stage of the receiving end, so the performance of the mixer is directly related to the performance of the entire receiver system. At the same time, since it is difficult to achieve a high-performance local oscillator in the same frequency band, sub-harmonic mixing technology is an effective way to solve this problem.

With increased requirements of system performance, requirements of receiver indexes are also increasing. To improve integration or imaging resolution, multi-channel integration of the receiver is a key issue. Because the current terahertz mixers mainly use metal cavity materials such as copper or aluminum, which can achieve a good channel spacing, multi-channel at present is still spliced by independent single channels. However, due to limitations of machining requirements of the metal cavity, it is difficult to reduce the multi-channel spacing to improve the overall integration.

CN20913360U concerns a terahertz mixer and an electronic device including the same. According to an embodiment, the terahertz mixer comprises a cavity used for respectively forming a radio frequency input waveguide and a local oscillator input waveguide, and used for accommodating a microstrip line; and the microstrip line is formed on at least one part of the inner side surface of the cavity through a semiconductor growth process, and the microstrip line respectively extends into the cavity where the radio frequency input waveguide and the local oscillator input waveguide are located so as to respectively form microstrip line antennas for receiving a radio frequency input signal and a local oscillator input signal.

CN109509952A concerns a terahertz mixer and a manufacturing method thereof, and an electronic device including the terahertz mixer. The terahertz mixer is characterized by comprising a chamber usedfor respectively forming a radio frequency (RF) input waveguide and a local oscillator input waveguide and further used for accommodating a microstrip line, and the microstrip line which is formed onat least a portion of an inner side surface of the chamber through the semiconductor growth process, wherein the microstrip line respectively extends to the cavity in which the RF input waveguide andthe local oscillator input waveguide are located to respectively form a microstrip line antenna for receiving an RF input signal and a local oscillator input signal.

CN202888829U concerns a strip-line antenna-feed lightning protection device relates to the antenna-feed lightning protection device technology field and solves a problem that a lightning protection device interface of a coaxialtype gas discharge tube can't turn and is difficult to debug. The lightning protection device comprises a housing, an input coaxial adapter and an output coaxial adapter and is characterized in that an input strip line and an output strip line are mounted in a cavity of the housing, one end of the input strip line is connected with a terminal of the input coaxial adapter and the other end passes through the gas discharge tube and is connected with the housing and one end of the output strip line, and the other end of the output strip line is connected with a terminal of the output coaxial adapter. By utilizing strip-line design, the device is simple in a structure and convenient in debugging, and can flexibly change mounting directions of the input coaxial adapter and the output coaxial adapter. Debugging is convenient and bearing power is high. A lightning protection effect is good, performances are reliable, and the device is without maintenance and is suitable for various radio-frequency receivingemission systems.

### SUMMARY

The purpose of the present disclosure is to solve at least one aspect of the above-mentioned problems and defects existing in the prior art.

The present invention concerns a device for mixing or multiplying frequency as defined in claim 1, a device for mixing or multiplying frequency as defined in claim 10, and a device for mixing or multiplying frequency as defined in claim 11. Further aspects of the present invention are defined in the dependent claims.

In the device of mixing or multiplying frequency according to the above various embodiments of the present disclosure, the direction where the signal output channel is led out is changed from a direction parallel to the plane where the microstrip line is located to a direction at an angle to the plane where the microstrip line is located, which avoids the problem of poor integration due to the presence of the radio frequency signal input channel, the local oscillator signal input channel and the signal output channel in the same plane.

### BRIEF DESCRIPTION OF THE DRAWINGS

FIG. 1 shows a schematic diagram of a terahertz mixer including a single frequency conversion unit according to an exemplary embodiment of the present invention.
FIG. 2 shows a schematic diagram of a terahertz mixer including a plurality of frequency conversion units according to another exemplary embodiment of the present invention.
FIG. 3 shows a schematic diagram of a terahertz mixer including a single frequency conversion unit according to yet another exemplary embodiment of the present invention.
FIG. 4 shows a schematic diagram of a terahertz mixer including a plurality of frequency conversion units according to yet another exemplary embodiment of the present invention.
FIG. 5 shows a schematic diagram of a glass insulator according to an exemplary embodiment of the present invention.
FIG. 6 shows a schematic diagram of a terahertz mixer including a single frequency conversion unit according to another exemplary embodiment of the present invention.
FIG. 7 shows a schematic diagram of a terahertz mixer including a plurality of frequency conversion units according to yet another exemplary embodiment of the present invention.
FIG. 8 shows a schematic diagram of a coaxial metal column structure according to an exemplary embodiment of the present invention.
FIG. 9 shows a schematic diagram of a distribution of a plurality of frequency conversion units of the terahertz mixer on the box body according to another exemplary embodiment of the present invention.
FIG. 10 shows a schematic diagram of a distribution of a plurality of frequency conversion units of the terahertz mixer on the cover according to another exemplary embodiment of the present invention.

### DETAILED DESCRIPTION

Although the present disclosure will be fully described with reference to the drawings containing the preferred embodiments of the present disclosure, it should be understood that those skilled in the art may modify the invention described herein while obtaining the technical effects of the present disclosure. Therefore, it should be understood that the above description is a broad disclosure for those ordinary skilled in the art, and its content is not intended to limit the exemplary embodiments described in the present disclosure.

In addition, in the following detailed description, for the convenience of explanation, many specific details are set forth to provide a comprehensive understanding of the embodiments of the present disclosure. Obviously, however, one or more embodiments may also be implemented without these specific details. In other cases, well-known structures and devices are shown in diagrammatic form to simplify the drawings.

According to a general inventive concept of the present disclosure, there is provided a device of mixing or multiplying frequency, including: a metal housing including a box body and a cover buckled together to define a metal cavity; at least one frequency conversion unit including a microstrip line located in the metal cavity; and a channel structure including a radio frequency signal input channel, a local oscillator signal input channel and a signal output channel respectively passing through the metal housing and coupled to the microstrip line, wherein the signal output channel is led out at an angle with respect to a plane where the microstrip line is located.

The terahertz mixer according to the present disclosure is a radio frequency transition microstrip line mixer, which mainly includes a metal housing and at least one frequency conversion unit located in the metal housing. The metal housing includes a box body and a cover buckled with the box body, for example, through a screw. A metal cavity may be defined in the metal housing when the box body and the cover are buckled together. In addition, the metal housing is further provided with a band port standard flange structure. In order to facilitate the connection of the cover and the box body, the terahertz mixer is further provided with alignment pins and the like.

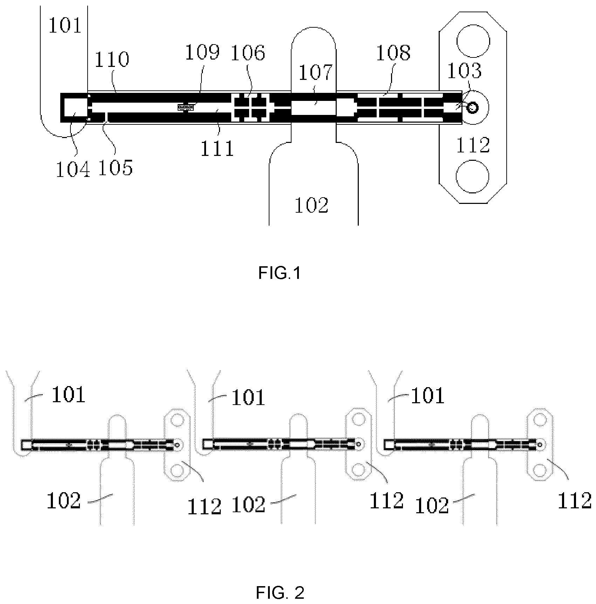

FIG. 1 shows a schematic diagram of a terahertz mixer including a single frequency conversion unit according to an exemplary embodiment of the present disclosure. FIG. 2 shows a schematic diagram of a terahertz mixer including a plurality of frequency conversion units according to another exemplary embodiment of the present disclosure.

As shown in FIGS. 1 and 2, the frequency conversion unit of the terahertz mixer includes a microstrip line 107 and a channel structure. The microstrip line 107 is located in the metal cavity. The channel structure includes a radio frequency signal input channel 101, a local oscillator signal input channel 102 and a signal output channel, which pass through the metal housing and are coupled to the microstrip line 107 respectively. A part of the microstrip line 107 respectively extends to the metal cavity where the radio frequency signal input channel 101 and the local oscillator signal input channel 102 are located, so as to form an antenna 104 for receiving radio frequency input signals and local oscillator input signals. Other composition parts and dimension parameters of the mixer may refer to the prior art, or other documents or patents.

The specific content of this solution will be described below in combination with more specific examples. It should be understood that the dimensions and proportions in the figures are only for illustration and have nothing to do with the actual structure.

As shown in FIGS. 1 and 2, the radio frequency signal input channel 101 and the local oscillator signal input channel 102 of the mixer according to the present disclosure are respectively formed in the box body (or cover) defining the metal cavity and are parallel to the plane where the microstrip line 107 is located, and the signal output channel (which is an intermediate frequency signal output channel in this embodiment) is perpendicular to the plane where the microstrip line 107 is located and is led out from the cover or box body through an SMA connector 112. The terahertz mixer changes, by using the SMA connector, a direction along which the intermediate frequency signal of the mixer is led out, from the direction parallel to the plane where the microstrip line 107 is located to the direction perpendicular to the plane where the microstrip line 107 is located, thereby avoiding the problem of poor integration due to the presence of the radio frequency signal input channel, the local oscillator signal input channel and the signal output channel in the same plane. Moreover, it reduces the complexity and processing cost of multi-channel integration while ensuring the basic high-frequency characteristics of the mixer, which improves the flexibility of the mixer integration mode, and provides favorable conditions for further system integration.

As shown in FIGS. 1 and 2, the SMA connector 112 is a wall-through structure and has a metal pin pointing outwards perpendicular to the principle plane. One end of the SMA connector 112 is level with the microstrip line 107 and connected to the intermediate frequency signal output port 103 of the microstrip line 107 through gold wire bonding, so as to realize a vertical extraction of the intermediate frequency signal. Those skilled in the art should understand that the SMA connector 112 may also adopt other connectors, such as a 2.92 mm connector.

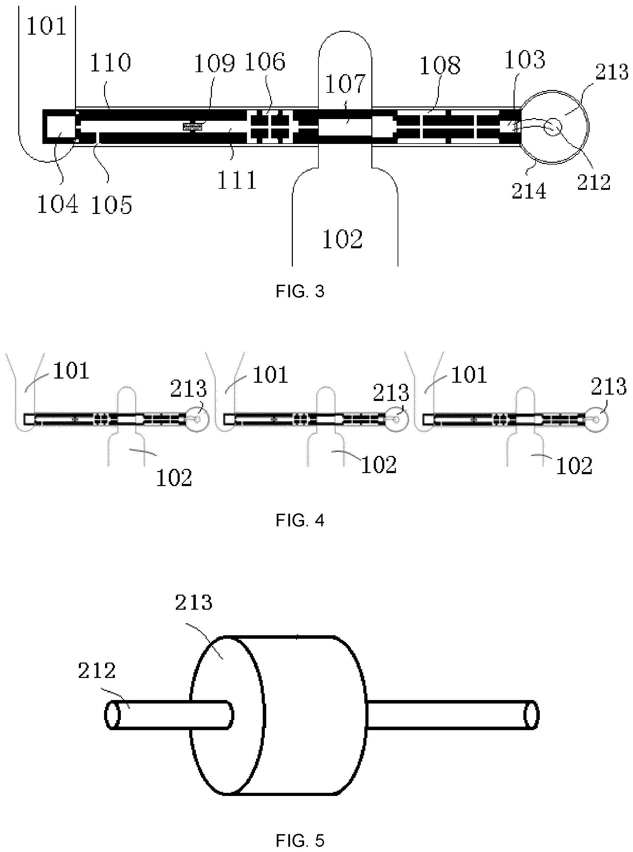

FIG. 3 shows a schematic diagram of a terahertz mixer including a single frequency conversion unit according to yet another exemplary embodiment of the present disclosure. FIG. 4 shows a schematic diagram of a terahertz mixer including a plurality of frequency conversion units according to yet another exemplary embodiment of the present disclosure. FIG. 5 shows a schematic diagram of a glass insulator according to an exemplary embodiment of the present disclosure.

In some embodiments of the present disclosure, as shown in FIGS. 3 and 4, the signal output channel is led out vertically through a glass insulator. Specifically, as shown in FIG. 5, the glass insulator includes a metal pin 212 and a first columnar portion 213 sheathed on the middle of the metal pin 212. The metal pin 212 points outwards perpendicular to the principle plane, with a first end being level with the microstrip line 107 and connected to the intermediate frequency signal output port 103 of the microstrip line 107 through gold wire bonding. The first columnar part 213 is made of insulating glass medium. A metal layer 214 is provided on an outer surface of the first columnar part 213. The first columnar part 213 is connected to the cover or box body defining the metal housing, for example, located in a hole formed in the cover or box body.

In some embodiments of the present disclosure, a second end of the metal pin 212 of the glass insulator, which is opposite to the first end, is connected with an SMA connector so as to be connected to an external component.

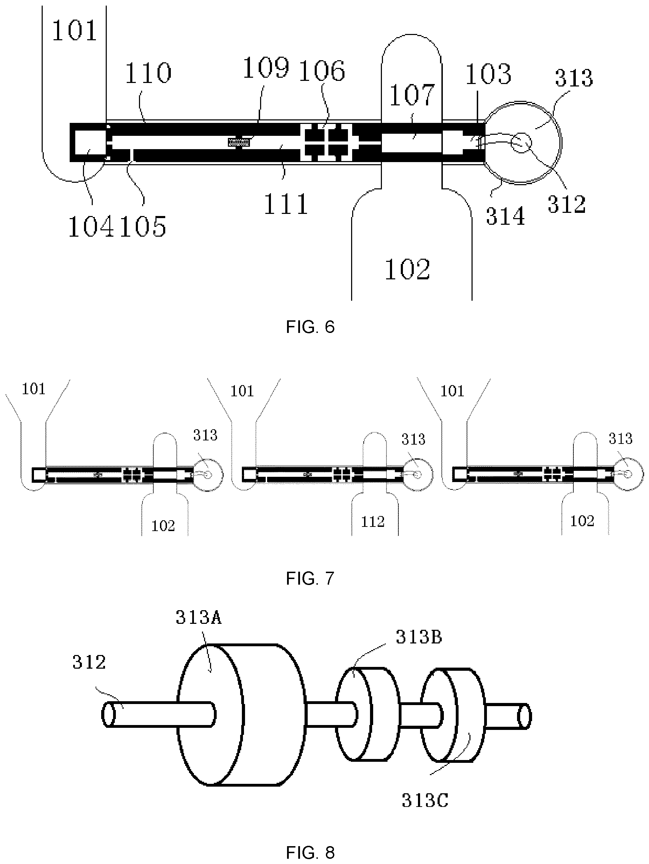

FIG. 6 shows a schematic diagram of a terahertz mixer including a single frequency conversion unit according to another exemplary embodiment of the present disclosure. FIG. 7 shows a schematic diagram of a terahertz mixer including a plurality of frequency conversion units according to yet another exemplary embodiment of the present disclosure. FIG. 8 shows a schematic diagram of a coaxial metal column structure according to an exemplary embodiment of the present disclosure.

In some embodiments of the present disclosure, as shown in FIGS. 6 and 7, the signal output channel is led out vertically through the coaxial metal column. Specifically, as shown in FIG. 8, the coaxial metal column includes a metal pin 312 and a plurality of second columnar parts 313A, 313B, 313C, which are spaced apart from each other and sleeved on the metal pin 312 along the axial direction of the metal pin 312. One of the second columnar parts 313A, 313B, 313C (preferably the one far away from the intermediate frequency signal output port 103) is connected to the metal housing. The metal pin 312 points outwards perpendicular to the principle plane, with a first end being level with the microstrip line 107 and connected to the intermediate frequency signal output port 103 of the microstrip line through gold wire bonding.

In an exemplary embodiment of the present disclosure, as shown in FIG. 8, one of adjacent two of the second columnar parts 313A, 313B, 313C has a diameter difference from the other of the adjacent two of the second columnar parts 313A, 313B, 313C. The coaxial metal column adopts second columnar parts with different diameters to form effective filter characteristics, so that radio frequency signals and local oscillator signals may be filtered to ensure the output of intermediate frequency signals. Since the coaxial metal column integrates a low-pass filter, the overall length of the quartz microstrip line is shortened, thereby improving the integration of the multi-channel mixer.

In some embodiments of the present disclosure, a second end of the metal pin 312 of the coaxial metal column, which is opposite to the first end, is connected with an SMA connector so as to be connected to an external component.

It should be noted that although in the above-mentioned embodiment, through the SMA connector or the glass insulator or the coaxial metal column, the direction along which the intermediate frequency signal of the mixer is led out is changed from the direction parallel to the plane where the microstrip line 107 is located to the direction perpendicular to the plane where the microstrip line 107 is located, those skilled in the art should understand that in some other embodiments of the present disclosure, the intermediate frequency signal extraction direction may also be at an angle with respect to the plane where the microstrip line 107 is located, and the angle is not equal to zero.

In some exemplary embodiments of the present disclosure, as shown in FIGS. 1-4, 6 and 7, the radio frequency signal input channel 101 and the local oscillator signal input channel 102 of the frequency conversion unit are both introduced perpendicular to the length of the microstrip line 107 and directly coupled to the microstrip line. Those skilled in the art should understand that in some other embodiments of the present disclosure, the radio frequency signal input channel 101 and the local oscillator signal input channel 102 of the frequency conversion unit may also be introduced in other directions. For example, the radio frequency signal input channel 101 and the local oscillator signal input channel 102 of the frequency conversion unit are both introduced parallel to the length of the microstrip line 107 and coupled to the microstrip line through a 90° turn.

In an exemplary embodiment of the present disclosure, as shown in FIGS. 1-4, 6 and 7, the radio frequency signal input channel 101 and the local oscillator signal input channel 102 of the frequency conversion unit are introduced in opposite directions, so as to avoid interference of the radio frequency signal input channel 101, the local oscillator signal input channel 102 and their associated components in spatial position, and also shorten the overall length of the microstrip line 107, thereby further improving the integration of the mixer. However, it should be noted that in some other embodiments of the present disclosure, the radio frequency signal input channel 101 and the local oscillator signal input channel 102 of the frequency conversion unit may also be introduced in the same direction. In addition, in some other embodiments of the present disclosure, the introduction directions of the radio frequency signal input channel 101 and the local oscillator signal input channel 102 of the frequency conversion unit may not be parallel.

In an exemplary embodiment, as shown in FIGS. 2, 4 and 7, in case that the device includes a plurality of frequency conversion units, the plurality of frequency conversion units are arranged in a row along the length of the microstrip line 107. However, those skilled in the art should understand that in some other embodiments of the present disclosure, other arrangements may also be adopted, and the specific arrangements may be adjusted according to requirements.

In the case where the radio frequency signal input channel 101 and the local oscillator signal input channel 102 of the frequency conversion unit are both introduced parallel to the length of the microstrip line 107 and coupled to the microstrip line 107 through a 90° turn, if the device includes a plurality of frequency conversion units, the plurality of frequency conversion units may be arranged in a row along the direction perpendicular to the length of the microstrip line 107. However, those skilled in the art should understand that in some other embodiments of the present disclosure, other arrangements may also be adopted, and the specific arrangements may be adjusted according to requirements.

In an exemplary embodiment, as shown in FIGS. 2, 4 and 7, the radio frequency signal input channels 101 of each row of frequency conversion units are parallel to each other and ports of the radio frequency signal input channels 101 are aligned with each other, and the local oscillator signal input channels 102 are parallel to each other and ports of the local oscillator signal input channels 102 are aligned with each other, so as to ensure that the signal reception of the multi-channel receiver and the input local oscillator signal are consistent.

The operating process of the above-mentioned mixer includes the following. The terahertz signal that needs to be received passes through the radio frequency signal input channel 101. In the waveguide-transition-microstrip line structure of the E-surface probe, the terahertz signal is transmitted to the antenna 104 of the microstrip line 107. The local oscillator signal enters from the local oscillator signal input channel 102, passes through a microstrip transition structure 107 of a duplexer and a local oscillator low-pass filter 106, and then mixes with the radio frequency signal in a gallium arsenide Schottky diode 109. The radio frequency signal is mixed with second harmonic of the local oscillator. The differential intermediate frequency signal passes through an intermediate frequency filter 108 to the intermediate frequency signal output port 103, and then is transmitted to a load through the SMA connector or glass insulator or coaxial metal column. In order to avoid DC offset caused by the inconsistency of the pair of Schottky diodes 109, a ground line 105 connected to the metal cavity is led out from the microstrip line 107, which may be applied to the nearest metal cavity by conductive silver glue, or may be welded to the nearest metal cavity by gold wire bonding.

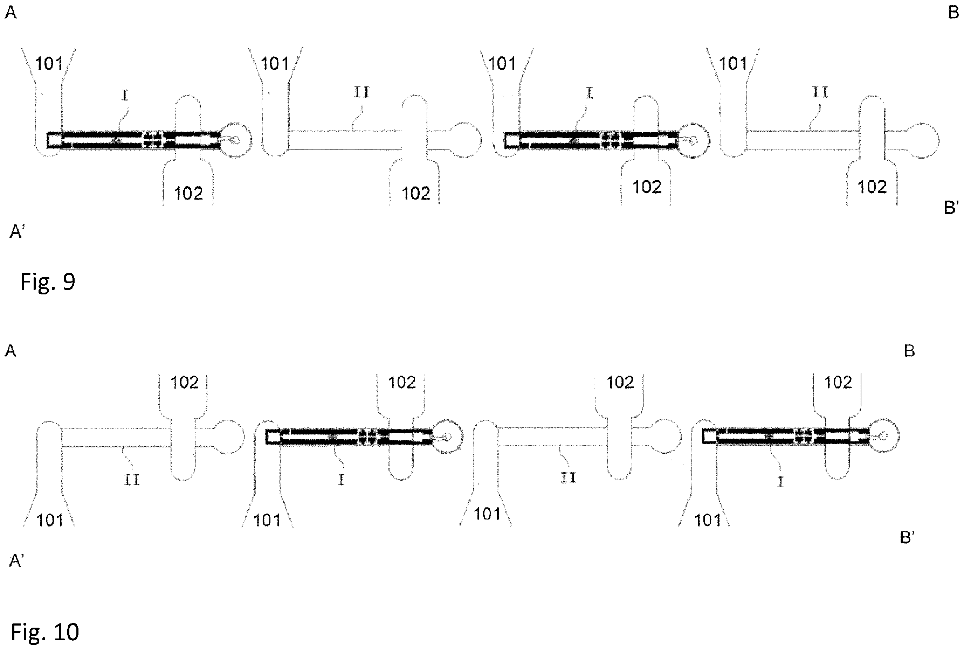

FIG. 9 shows a schematic diagram of a distribution of a plurality of frequency conversion units of the terahertz mixer on the box body according to another exemplary embodiment of the present disclosure. FIG. 10 shows a schematic diagram of a distribution of a plurality of frequency conversion units of the terahertz mixer on the cover according to another exemplary embodiment of the present disclosure.

In an exemplary embodiment, as shown in FIGS. 9 and 10, in case that the device includes a plurality of frequency conversion units, the plurality of frequency conversion units are divided into two groups, which are respectively arranged in the box body (see FIG. 9) and the cover (see FIG. 10) and arranged in mirror symmetry. Specifically, a microstrip line assembly position I of the frequency conversion unit in the cover corresponds to an air cavity position II on the microstrip line of the frequency conversion unit in the box body, and the air cavity position II on the microstrip line of the frequency conversion unit in the cover corresponds to the microstrip line assembly position I of the frequency conversion unit in the box body. In this way, the upper and lower adjacent channels have opposite intermediate frequency signal extraction directions, so as to be led out from the box body and the cover respectively, thereby reserving a large space for the SMA connector or glass insulator or coaxial metal column. If the SMA connector or glass insulator or coaxial metal column has the maximum outer diameter of a, then it is only needed to ensure that the spacing between channels is not less than a/2. If the spacing between channels needs to be further reduced, a custom small-size connector on the intermediate frequency output port may be employed.

In an exemplary embodiment, as shown in FIG. 9 and FIG. 10, the signal output channels 103 of each row of frequency conversion units are parallel to each other, and two adjacent signal output channels are led out in opposite directions, so as to further reserve a large space for the SMA connector or glass insulator or coaxial metal column.

In an exemplary embodiment, as shown in FIG. 9 and FIG. 10, A-A' to B'-B are marked at the corresponding positions of the box body and the cover to avoid incorrect buckling.

It should be noted that if the device includes a plurality of frequency conversion units, the plurality of frequency conversion units may be one group all arranged on the box body or all arranged on the cover.

In an exemplary embodiment, the local oscillator signal input channels 102 of the plurality of frequency conversion units may be collected to a port through a (one to four, or one to eight) power divider, and then input signals through the local oscillator source, so as to realize the simultaneous operation of the mixer.

It should be noted that the microstrip line 107 may be a quartz substratebased microstrip line structure, or a sapphire-based microstrip line structure, or a common microstrip line structure, or a suspended microstrip line structure, or a monolithic integrated microstrip circuit of gallium arsenide (GaAs), or a monolithic integrated microstrip circuit of indium phosphide (InP). In addition, the material of the metal housing includes but is not limited to alloy metals such as aluminum or brass, and semiconductor materials based on silicon, or gallium arsenide, indium phosphide, and the like. The metal cavity defined by the metal housing may be a shielded cavity structure with a metal inner wall processed by a Micro-Electro-Mechanical System (MEMS) technology, or a shielded cavity structure with a metal inner wall processed by a micro-coaxial technology.

In addition, in an exemplary embodiment of the present disclosure, the antenna 104 may be integrated and processed together with the radio frequency signal input channel 101. The size of the antenna 104 may be optimized according to the channel spacing to ensure the system's requirements for receiver parameters..

In addition, those skilled in the art should understand that the harmonic type of the mixer is not limited, and it may be a single-ended, single-balanced, double-balanced, triple-balanced, or I/Q passive mixer. The plurality of local oscillator signal input channels of the mixer may be collected to a port through a (one to four, or one to eight) power divider, and then input signals through the local oscillator source, so as to realize the simultaneous operation of the mixer.

The terahertz mixer changes the direction along which the intermediate signal of the mixer is led out, from the direction parallel to the plane where the microstrip line 107 is located to the direction perpendicular to the plane where the microstrip line 107 is located, thereby avoiding the problem of poor integration due to the presence of the radio frequency signal input channel, the local oscillator signal input channel and the signal output channel in the same plane. Moreover, it reduces the complexity and processing cost of multi-channel integration while ensuring the basic high-frequency characteristics of the mixer, which improves the flexibility of the mixer integration mode, and provides favorable conditions for further system integration. In addition, although the foregoing embodiments are all described by taking the mixer as an example, those skilled in the art should understand that in some other embodiments of the present disclosure, the device is also applicable to a frequency multiplier.

Those skilled in the art may understand that the embodiments described above are exemplary, and those skilled in the art may make improvements.

After describing the preferred embodiments of the present disclosure in detail, those skilled in the art may clearly understand that various changes and modifications may be made, and the present disclosure is not limited to the exemplary embodiments described in the present disclosure.

## Claims

1. A device for mixing or multiplying frequency, comprising:
a metal housing, comprising a box body and a cover buckled together to define a metal cavity;
at least one frequency conversion unit, comprising:
a microstrip line (107) located in the metal cavity; and
a channel structure comprising a radio frequency signal input channel (101), a local oscillator signal input channel (102) and a signal output channel, the radio frequency signal input channel (101), the local oscillator signal input channel (102) and the signal output channel pass through the metal housing and are coupled to the microstrip line (107) respectively,
**characterized in that**
the signal output channel is led out at an angle with respect to a plane where the microstrip line (107) is located,
wherein the signal output channel is led out by using an SMA connector (112), the SMA connector (112) is a wall-through structure and has a metal pin pointing outwards perpendicular to the principle plane, one end of the SMA connector (112) is level with the microstrip line (107) and connected to an intermediate frequency signal output port (103) of the microstrip line (107) through gold wire bonding, so as to realize a vertical extraction of an intermediate frequency signal.

2. The device according to claim 1, wherein the signal output channel is perpendicular to the plane where the microstrip line (107) is located.

3. The device according to any of claims 1 or 2, wherein the radio frequency signal input channel (101) and the local oscillator signal input channel (102) of the frequency conversion unit are both introduced into the microstrip line (107) in a direction perpendicular to a length of the microstrip line (107) and are coupled to the microstrip line (107).

4. The device according to claim 3, wherein the radio frequency signal input channel (101) and the local oscillator signal input channel (102) of the frequency conversion unit are introduced in opposite directions.

5. The device according to claim 4, wherein the device includes a plurality of frequency conversion units, the plurality of frequency conversion units are divided into one group or two groups, and the frequency conversion units of each group are arranged in a row along the length of the microstrip line (107).

6. The device according to claim 5, wherein the plurality of frequency conversion units are divided into two groups, the two groups of frequency conversion units are respectively arranged in the box body and the cover and are arranged in mirror symmetry.

7. The device according to claim 6, wherein the radio frequency signal input channels (101) of each row of the frequency conversion units are parallel to each other and ports of the radio frequency signal input channels (101) of each row of the frequency conversion units are aligned with each other, and the local oscillator signal input channels (102) of each row of the frequency conversion units are parallel to each other and ports of the local oscillator signal input channels (102) of each row of the frequency conversion units are aligned with each other.

8. The device according to claim 7, wherein the signal output channels of each row of the frequency conversion units are parallel to each other, and two adjacent signal output channels in each row of the frequency conversion units are led out in opposite directions.

9. The device according to any of claims 1 or 2, wherein the device includes a plurality of frequency conversion units, the local oscillator signal input channels (102) of the plurality of frequency conversion units are collected to one port through a power divider.

10. A device for mixing or multiplying frequency, comprising:
a metal housing, comprising a box body and a cover buckled together to define a metal cavity;
at least one frequency conversion unit, comprising:
a microstrip line (107) located in the metal cavity; and
a channel structure comprising a radio frequency signal input channel (101), a local oscillator signal input channel (102) and a signal output channel, the radio frequency signal input channel (101), the local oscillator signal input channel (102) and the signal output channel pass through the metal housing and are coupled to the microstrip line (107) respectively,
**characterized in that**
the signal output channel is led out at an angle with respect to a plane where the microstrip line (107) is located,
wherein the signal output channel is led out by using a glass insulator, the glass insulator comprises a metal pin (212) and a first columnar portion (213) sheathed on the middle of the metal pin (212), the metal pin (212) points outwards perpendicular to the principle plane, with a first end being level with the microstrip line (107) and connected to an intermediate frequency signal output port (103) of the microstrip line (107) through gold wire bonding.

11. A device for mixing or multiplying frequency, comprising:
a metal housing, comprising a box body and a cover buckled together to define a metal cavity;
at least one frequency conversion unit, comprising:
a microstrip line (107) located in the metal cavity; and
a channel structure comprising a radio frequency signal input channel (101), a local oscillator signal input channel (102) and a signal output channel, the radio frequency signal input channel (101), the local oscillator signal input channel (102) and the signal output channel pass through the metal housing and are coupled to the microstrip line (107) respectively,
**characterized in that**
the signal output channel is led out at an angle with respect to a plane where the microstrip line (107) is located,
wherein the signal output channel is led out by using a coaxial metal column structure, the coaxial metal column structure includes a metal pin (312) and a plurality of second columnar parts (313A, 313B, 313C) spaced apart from each other and sleeved on the metal pin (312) along an axial direction of the metal pin (312), one of the second columnar parts (313A, 313B, 313C) is connected to the metal housing, the metal pin (312) points outwards perpendicular to the principle plane, with a first end being level with the microstrip line (107) and connected to an intermediate frequency signal output port (103) of the microstrip line (107) through gold wire bonding.

12. The device according to claim 11, wherein one of adjacent two of the second columnar parts (313A, 313B, 313C) has a diameter different from the other of the adjacent two of the second columnar parts (313A, 313B, 313C).

## Patentansprüche

1. Vorrichtung zum Mischen oder Multiplizieren von Frequenzen, die umfasst:
ein Metallgehäuse umfassend einen Gehäusekörper und eine Abdeckung, die so zusammengepresst sind, dass sie einen Metallhohlraum bilden;
mindestens eine Frequenzumwandlungseinheit, umfassend:
eine Mikrostreifenleitung (107), die sich in dem Metallhohlraum befindet; und
eine Kanalstruktur mit einem Hochfrequenzsignal-Eingangskanal (101), einem Lokaloszillator-Signaleingangskanal (102) und einem Signalausgangskanal, wobei der Hochfrequenzsignal-Eingangskanal (101), der Lokaloszillator-Signaleingangskanal (102) und der Signalausgangskanal durch das Metallgehäuse verlaufen und jeweils mit der Mikrostreifenleitung (107) gekoppelt sind,
**dadurch gekennzeichnet, dass**
der Signalausgangskanal in einem Winkel in Bezug auf eine Ebene herausgeführt ist, in der sich die Mikrostreifenleitung (107) befindet,
wobei der Signalausgangskanal unter Verwendung eines SMA-Verbinders (112) herausgeführt ist, der SMA-Verbinder (112) eine Wanddurchgangsstruktur ist und einen Metallstift aufweist, der senkrecht zur Hauptebene nach außen zeigt, ein Ende des SMA-Verbinders (112) auf gleicher Höhe mit der Mikrostreifenleitung (107) ist und mit einem Zwischenfrequenzsignal-Ausgangsanschluss (103) der Mikrostreifenleitung (107) durch Golddraht-Bonden verbunden ist, um eine vertikale Extraktion eines Zwischenfrequenzsignals zu realisieren.

2. Vorrichtung nach Anspruch 1, wobei der Signalausgangskanal senkrecht zu der Ebene verläuft, in der sich die Mikrostreifenleitung (107) befindet.

3. Vorrichtung nach einem der Ansprüche 1 oder 2, wobei der Hochfrequenzsignal-Eingangskanal (101) und der Lokaloszillator-Signaleingangskanal (102) der Frequenzumwandlungseinheit beide in die Mikrostreifenleitung (107) in einer Richtung senkrecht zu einer Länge der Mikrostreifenleitung (107) eingeführt und mit der Mikrostreifenleitung (107) gekoppelt sind.

4. Vorrichtung nach Anspruch 3, wobei der Hochfrequenzsignal-Eingangskanal (101) und der Lokaloszillator-Signaleingangskanal (102) der Frequenzumwandlungseinheit in entgegengesetzten Richtungen eingeführt sind.

5. Vorrichtung nach Anspruch 4, wobei die Vorrichtung eine Vielzahl von Frequenzumwandlungseinheiten enthält, die Vielzahl von Frequenzumwandlungseinheiten in eine Gruppe oder zwei Gruppen unterteilt sind und die Frequenzumwandlungseinheiten jeder Gruppe in einer Reihe entlang der Länge der Mikrostreifenleitung (107) angeordnet sind.

6. Vorrichtung nach Anspruch 5, bei der die mehreren Frequenzumwandlungseinheiten in zwei Gruppen unterteilt sind, wobei die beiden Gruppen von Frequenzumwandlungseinheiten jeweils in dem Gehäusekörper und der Abdeckung angeordnet und spiegelsymmetrisch angeordnet sind.

7. Vorrichtung nach Anspruch 6 , wobei die Hochfrequenzsignal-Eingangskanäle (101) jeder Reihe der Frequenzumwandlungseinheiten parallel zueinander sind und die Anschlüsse der Hochfrequenzsignal-Eingangskanäle (101) jeder Reihe der Frequenzumwandlungseinheiten aufeinander ausgerichtet sind, und die Lokaloszillator-Signaleingangskanäle (102) jeder Reihe der Frequenzumwandlungseinheiten parallel zueinander sind und Anschlüsse der Lokaloszillator-Signaleingangskanäle (102) jeder Reihe der Frequenzumwandlungseinheiten aufeinander ausgerichtet sind.

8. Vorrichtung nach Anspruch 7, wobei die Signalausgangskanäle jeder Reihe der Frequenzumwandlungseinheiten parallel zueinander sind und zwei benachbarte Signalausgangskanäle in jeder Reihe der Frequenzumwandlungseinheiten in entgegengesetzte Richtungen herausgeführt sind.

9. Vorrichtung nach einem der Ansprüche 1 oder 2, wobei die Vorrichtung eine Vielzahl von Frequenzumwandlungseinheiten umfasst, wobei die Lokaloszillator-Signaleingangskanäle (102) der Vielzahl von Frequenzumwandlungseinheiten über einen Leistungsteiler zu einem Anschluss gesammelt werden.

10. Vorrichtung zum Mischen oder Multiplizieren von Frequenzen, die umfasst:
ein Metallgehäuse umfassend einen Gehäusekörper und eine Abdeckung, die so zusammengepresst sind, dass sie einen Metallhohlraum bilden;
mindestens eine Frequenzumwandlungseinheit, umfassend:
eine Mikrostreifenleitung (107), die sich in dem Metallhohlraum befindet; und
eine Kanalstruktur mit einem Hochfrequenzsignal-Eingangskanal (101), einem Lokaloszillator-Signaleingangskanal (102) und einem Signalausgangskanal, wobei der Hochfrequenzsignal-Eingangskanal (101), der Lokaloszillator-Signaleingangskanal (102) und der Signalausgangskanal durch das Metallgehäuse verlaufen und jeweils mit der Mikrostreifenleitung (107) gekoppelt sind,
**dadurch gekennzeichnet, dass**
der Signalausgangskanal in einem Winkel in Bezug auf eine Ebene herausgeführt ist, in der sich die Mikrostreifenleitung (107) befindet,
wobei der Signalausgangskanal unter Verwendung eines Glasisolators herausgeführt ist, wobei der Glasisolator einen Metallstift (212) und einen ersten säulenförmigen Abschnitt (213) umfasst, der in der Mitte des Metallstifts (212) ummantelt ist, wobei der Metallstift (212) senkrecht zur Hauptebene nach außen zeigt, wobei ein erstes Ende auf gleicher Höhe mit der Mikrostreifenleitung (107) ist und mit einem Zwischenfrequenzsignal-Ausgangsanschluss (103) der Mikrostreifenleitung (107) durch Golddraht-Bonden verbunden ist.

11. Vorrichtung zum Mischen oder Multiplizieren von Frequenzen, die umfasst:
ein Metallgehäuse umfassend einen Gehäusekörper und eine Abdeckung, die so zusammengepresst sind, dass sie einen Metallhohlraum bilden;
mindestens eine Frequenzumwandlungseinheit, umfassend:
eine Mikrostreifenleitung (107), die sich in dem Metallhohlraum befindet; und
eine Kanalstruktur mit einem Hochfrequenzsignal-Eingangskanal (101), einem Lokaloszillator-Signaleingangskanal (102) und einem Signalausgangskanal, wobei der Hochfrequenzsignal-Eingangskanal (101), der Lokaloszillator-Signaleingangskanal (102) und der Signalausgangskanal durch das Metallgehäuse verlaufen und jeweils mit der Mikrostreifenleitung (107) gekoppelt sind,
**dadurch gekennzeichnet, dass**
der Signalausgangskanal in einem Winkel in Bezug auf eine Ebene herausgeführt ist, in der sich die Mikrostreifenleitung (107) befindet,
wobei der Signalausgangskanal unter Verwendung einer koaxialen Metallsäulenstruktur herausgeführt ist, wobei die koaxiale Metallsäulenstruktur einen Metallstift (312) und eine Vielzahl von zweiten säulenförmigen Teilen (313A, 313B, 313C) umfasst, die voneinander beabstandet sind und auf dem Metallstift (312) entlang einer axialen Richtung des Metallstifts (312) umhüllt sind, eines der zweiten säulenförmigen Teile (313A, 313B, 313C) mit dem Metallgehäuse verbunden ist, der Metallstift (312) senkrecht zur Hauptebene nach außen zeigt, wobei ein erstes Ende auf der Höhe der Mikrostreifenleitung (107) liegt und mit einem Zwischenfrequenzsignal-Ausgangsanschluss (103) der Mikrostreifenleitung (107) durch Golddraht-Bonden verbunden ist.

12. Vorrichtung nach Anspruch 11, wobei einer der beiden benachbarten zweiten säulenförmigen Teile (313A, 313B, 313C) einen anderen Durchmesser hat als der andere der beiden benachbarten zweiten säulenförmigen Teile (313A, 313B, 313C).

## Revendications

1. Dispositif de mélange ou de multiplication de fréquence, comprenant:
un logement métallique comprenant un corps de boîte et un couvercle attachés ensemble pour définir une cavité métallique;
au moins une unité de conversion de fréquence, comprenant:
une ligne de microruban (107) située dans la cavité métallique; et
une structure de canal comprenant un canal d'entrée de signal de radiofréquence (101), un canal d'entrée de signal d'oscillateur local (102) et un canal de sortie de signal, le canal d'entrée de signal de radiofréquence (101), le canal d'entrée de signal d'oscillateur local (102) et le canal de sortie de signal traversent le logement métallique et sont accouplés à la ligne de microruban (107) respectivement,
**caractérisé en ce que**
le canal de sortie de signal sort à un angle par rapport à un plan où est située la ligne de microruban (107),
dans lequel le canal de sortie de signal sort à l'aide d'un connecteur SMA (112), le connecteur SMA (112) est une structure de passage et a une tige métallique pointant vers l'extérieur perpendiculairement au plan principal, une extrémité du connecteur SMA (112) est au niveau de la ligne de microruban (107) et reliée à un port de sortie de signal de fréquence intermédiaire (103) de la ligne de microruban (107) par soudure de fil d'or, de manière à réaliser une extraction verticale d'un signal de fréquence intermédiaire.

2. Dispositif selon la revendication 1, dans lequel le canal de sortie de signal est perpendiculaire au plan où est située la ligne de microruban (107).

3. Dispositif selon l'une quelconque des revendications 1 ou 2, dans lequel le canal d'entrée de signal de radiofréquence (101) et le canal d'entrée de signal d'oscillateur local (102) de l'unité de conversion de fréquence sont tous les deux introduits dans la ligne de microruban (107) dans une direction perpendiculaire à une longueur de la ligne de microruban (107) et sont accouplés à la ligne de microruban (107).

4. Dispositif selon la revendication 3, dans lequel le canal d'entrée de signal de radiofréquence (101) et le canal d'entrée de signal d'oscillateur local (102) de l'unité de conversion de fréquence sont introduits dans des directions opposées.

5. Dispositif selon la revendication 4, dans lequel le dispositif comprend une pluralité d'unités de conversion de fréquence, la pluralité d'unités de conversion de fréquence sont divisées en un groupe ou en deux groupes, et les unités de conversion de fréquence de chaque groupe sont disposées dans une rangée dans le sens de la longueur de la ligne de microruban (107).

6. Dispositif selon la revendication 5, dans lequel la pluralité d'unités de conversion de fréquence sont divisées en deux groupes, les deux groupes d'unités de conversion de fréquence sont respectivement disposés dans le corps de boîte et le couvercle et sont disposés en symétrie miroir.

7. Dispositif selon la revendication 6, dans lequel les canaux d'entrée de signal de radiofréquence (101) de chaque rangée des unités de conversion de fréquence sont parallèles entre eux et des ports des canaux d'entrée de signal de radiofréquence (101) de chaque rangée des unités de conversion de fréquence sont alignés entre eux, et les canaux d'entrée de signal d'oscillateur local (102) de chaque rangée des unités de conversion de fréquence sont parallèles entre eux et des ports des canaux d'entrée de signal d'oscillateur local (102) de chaque rangée des unités de conversion de fréquence sont alignés entre eux.

8. Dispositif selon la revendication 7, dans lequel les canaux de sortie de signal de chaque rangée des unités de conversion de fréquence sont parallèles entre eux, et deux canaux de sortie de signal adjacents dans chaque rangée des unités de conversion de fréquence sortent dans des directions opposées.

9. Dispositif selon l'une quelconque des revendications 1 ou 2, dans lequel le dispositif comprend une pluralité d'unités de conversion, les canaux d'entrée de signal d'oscillateur local (102) de la pluralité d'unités de conversion de fréquence sont collectés dans un port par un diviseur de puissance.

10. Dispositif de mélange ou de multiplication de fréquence, comprenant:
un logement métallique comprenant un corps de boîte et un couvercle attachés ensemble pour définir une cavité métallique;
au moins une unité de conversion de fréquence, comprenant:
une ligne de microruban (107) située dans la cavité métallique; et
une structure de canal comprenant un canal d'entrée de signal de radiofréquence (101), un canal d'entrée de signal d'oscillateur local (102) et un canal de sortie de signal, le canal d'entrée de signal de radiofréquence (101), le canal d'entrée de signal d'oscillateur local (102) et le canal de sortie de signal traversent le logement métallique et sont accouplés à la ligne de microruban (107) respectivement,
**caractérisé en ce que**
le canal de sortie de signal sort à un angle par rapport à un plan où est située la ligne de microruban (107),
dans lequel le canal de sortie de signal sort à l'aide d'un isolateur en verre, l'isolateur en verre comprend une tige métallique (212) et une première partie colonnaire (213) mise dans une gaine au centre de la tige métallique (212), la tige métallique (212) pointe vers l'extérieur perpendiculairement au plan principal, une première extrémité étant au niveau de la ligne de microruban (107) et reliée à un port de sortie de signal de fréquence intermédiaire (103) de la ligne de microruban (107) par soudure par fil d'or.

11. Dispositif de mélange ou de multiplication de fréquence, comprenant:
un logement métallique comprenant un corps de boîte et un couvercle attachés ensemble pour définir une cavité métallique;
au moins une unité de conversion de fréquence, comprenant:
une ligne de microruban (107) située dans la cavité métallique; et
une structure de canal comprenant un canal d'entrée de signal de radiofréquence (101), un canal d'entrée de signal d'oscillateur local (102) et un canal de sortie de signal, le canal d'entrée de signal de radiofréquence (101), le canal d'entrée de signal d'oscillateur local (102) et le canal de sortie de signal traversent le logement métallique et sont accouplés à la ligne de microruban (107) respectivement,
**caractérisé en ce que**
le canal de sortie de signal sort à un angle par rapport à un plan où est située la ligne de microruban (107),
dans lequel le canal de sortie de signal sort à l'aide d'une structure de colonne métallique coaxiale, la structure de colonne métallique coaxiale comprend une tige métallique (312) et une pluralité de secondes parties colonnaires (313A, 313B, 313C) espacées les unes des autres et emmanchées sur la tige métallique (312) dans un sens axial de la tige métallique (312), l'une des secondes parties colonnaires (313A, 313B, 313C) est reliée au logement métallique, la tige métallique (312) pointe vers l'extérieur perpendiculairement au plan principal, une première extrémité étant au niveau de la ligne de microruban (107) et reliée à un port de sortie de signal de fréquence intermédiaire (103) de la ligne de microruban (107) par soudure de fil d'or.

12. Dispositif selon la revendication 11, dans lequel l'une des deux adjacentes parmi les secondes parties colonnaires (313A, 313B, 313C) a un diamètre différent de l'autre des deux adjacentes parmi les secondes parties colonnaires (313A, 313B, 313C).
